# EUROPEAN PATENT APPLICATION

(11) **EP 4 156 154 A1**
(43) Date of publication of application: **29.03.2023**
(21) Application number: 21807756.8
(22) Date of filing: 28.04.2021
(51) Int. Cl.: G09F 9/33

(54) **LIGHT-EMITTING MODULE, DISPLAY MODULE, DISPLAY SCREEN, AND DISPLAY**

(30) Priority: 22.05.2020 CN 202010440072
(71) Applicant: Beijing Ivisual 3D Technology Co., Ltd., Beijing 100055 (CN); Visiotech Ventures Pte. Ltd., Singapore 188979 (SG)
(72) Inventor: DIAO, Honghao, Beijing 100055 (CN); HUANG, Lingxi, Singapore 188979 (SG)
(74) Representative: Zacco GmbH
(86) International application number: PCT/CN2021/090529
(87) International publication number: WO 2021/233095

(57) **Abstract**

The present application relates to the technical field of optics, and discloses a light-emitting module (100), comprising: an electrical connection layer (130), a light-emitting unit layer (150) and a light conversion layer (170), wherein the light-emitting unit layer (150) is provided with no epitaxial growth substrate (190), or is provided with an epitaxial growth substrate (190) at least partially covering the light-emitting unit layer (150). In terms of the light-emitting module (100), the formed light-emitting module is provided with no epitaxial growth substrate (190) for forming the light-emitting unit layer (150), or is provided with the epitaxial growth substrate (190) at least partially covering the light-emitting unit layer (150), to prevent influence of the epitaxial growth substrate (190) on light which supports display as much as possible, thereby benefiting improvement of display effect. The present application further discloses a display module, a display screen and a display.

## Description

The present application claims priority to the Chinese Patent Application with an application number of 202010440072.3 and a title of "*Light-emitting Module, Display Module, Display Screen and Display*", filed to China National Intellectual Property Administration on May, 22nd, 2020, the disclosures of which are hereby incorporated by reference.

### TECHNICAL FIELD

The present application relates to the technical field of optics, and for example, relates to a light-emitting module, a display module, a display screen and a display.

### BACKGROUND

At present, a light-emitting unit layer capable of being used for display may be formed on a substrate in the manner of epitaxial growth.

In a process of implementing embodiments of the present disclosure, at least the following problems are found in related technologies:
An epitaxial growth substrate for forming the light-emitting unit layer easily influences light which supports the display, thereby influencing a display effect.

### SUMMARY

In order to provide a basic understanding of some aspects of the disclosed embodiments, a brief summary is given below. The summary is not intended to be a general comment, nor to identify key/important components or describe the scope of protection of the embodiments, but to be a preface to the following detailed description.

Embodiments of the present disclosure provide a light-emitting module, a display module, a display screen and a display, to solve a technical problem that an epitaxial growth substrate for forming the light-emitting unit layer easily influences light which supports display, thereby influencing a display effect.

The light-emitting module provided by embodiments of the present disclosure comprises an electrical connection layer, a light-emitting unit layer and a light conversion layer, wherein the light-emitting unit layer is provided with no epitaxial growth substrate, or is provided with an epitaxial growth substrate at least partially covering the light-emitting unit layer.

In some embodiments, the light-emitting unit layer is provided with no epitaxial growth substrate; and the light conversion layer may be directly arranged at the light-emitting unit layer.

In some embodiments, an intermediate layer structure that does not belong to the epitaxial growth substrate may further be arranged between the light conversion layer and the light-emitting unit layer.

In some embodiments, the intermediate layer structure may be in direct contact with the light-emitting unit layer, or may not be in direct contact with the light-emitting unit layer.

In some embodiments, the light-emitting unit layer may be provided with the epitaxial growth substrate, wherein
the epitaxial growth substrate may cover a part or whole of a non-light-transmissive region of the light-emitting unit layer; or
the epitaxial growth substrate may partially cover a light-transmissive region of the light-emitting unit layer; or
the epitaxial growth substrate may cover a part or whole of the non-light-transmissive region of the light-emitting unit layer, and partially cover the light-transmissive region of the light-emitting unit layer.

In some embodiments, an intermediate layer structure that does not belong to the epitaxial growth substrate may further be arranged between the light conversion layer and the light-emitting unit layer.

In some embodiments, the intermediate layer structure may be in direct contact with the light-emitting unit layer, or may not be in direct contact with the light-emitting unit layer in a region of the light-emitting unit layer not covered by the epitaxial growth substrate. Optionally, the intermediate layer structure may be in direct contact with the epitaxial growth substrate, or may not be in direct contact with the epitaxial growth substrate in the region of the light-emitting unit layer covered by the epitaxial growth substrate.

In some embodiments, a part or whole of the epitaxial growth substrate may be thinned when the light-emitting module is provided with the epitaxial growth substrate.

In some embodiments, the intermediate layer structure may be arranged independently of the light-emitting unit layer and the light conversion layer. Optionally, the intermediate layer structure may comprise a partial structure of at least one of the light-emitting unit layer and the light conversion layer.

In some embodiments, the intermediate layer structure may comprise a bottom layer for bearing a light conversion material in the light conversion layer.

In some embodiments, the intermediate layer structure may comprise a light-transmissive material.

In some embodiments, the light-emitting unit layer may be arranged between the electrical connection layer and the light conversion layer.

In some embodiments, the light conversion layer may be arranged at a light-exiting surface of the light-emitting unit layer.

In some embodiments, the light conversion layer may comprise a plurality of pixel units.

In some embodiments, the plurality of pixel units may comprise: at least one of pixels and subpixels.

In some embodiments, at least two pixel units of the plurality of pixel units may comprise the same or different light conversion materials.

In some embodiments, the electrical connection layer may be arranged at a backlight surface of the light-emitting unit layer.

In some embodiments, the electrical connection layer may be provided with a plurality of conductive holes; and the electrical connection layer may be electrically connected with the light-emitting unit layer through the plurality of conductive holes.

In some embodiments, the electrical connection layer may at least comprise a first electrical connection layer and a second electrical connection layer; and the first electrical connection layer and the second electrical connection layer may be electrically connected with the light-emitting unit layer through the plurality of conductive holes.

In some embodiments, the light-emitting unit layer may be provided with a plurality of light-emitting units; and at least one of the plurality of light-emitting units may be provided with at least one first electrode and at least one second electrode. Optionally, the plurality of conductive holes may comprise at least a plurality of first conductive holes and a plurality of second conductive holes. Optionally, at least one first electrode may be electrically connected with the first electrical connection layer through at least one of the plurality of first conductive holes; and at least one second electrode may be electrically connected with the second electrical connection layer through at least one of the plurality of second conductive holes.

In some embodiments, each light-emitting unit of the plurality of light-emitting units may be provided with a first electrode and a second electrode. Optionally, the plurality of conductive holes may comprise a plurality of first conductive holes and a plurality of second conductive holes. Optionally, the first electrodes of different light-emitting units in the plurality of light-emitting units may be electrically connected with the first electrical connection layer through different first conductive holes; and the second electrodes of different light-emitting units in the plurality of light-emitting units may be electrically connected with the second electrical connection layer through different second conductive holes.

In some embodiments, at least one of the first electrical connection layer and the second electrical connection layer may be arranged in the following modes:
the first electrical connection layer comprises at least one layer of first conductive lines;
the second electrical connection layer comprises at least one layer of second conductive lines.

In some embodiments, at least one of the first conductive lines and the second conductive lines may be in array arrangement.

In some embodiments, at least one of the first conductive lines and the second conductive lines may be in array arrangement in a form of rows or columns.

In some embodiments, the plurality of light-emitting units may be in array arrangement.

In some embodiments, the plurality of light-emitting units may be in array arrangement in a form of rows or columns.

In some embodiments, the first electrodes of the plurality of light-emitting units in at least one row may be electrically connected with the same first conductive line; and the second electrodes of the plurality of light-emitting units in at least one column may be electrically connected with the same second conductive line.

In some embodiments, the plurality of light-emitting units may comprise at least one of a light-emitting diode (LED), a Mini LED and a Micro LED.

The display module provided by embodiments of the present disclosure comprises the light-emitting module.

The display screen provided by embodiments of the present disclosure comprises the display module.

The display provided by embodiments of the present disclosure comprises the display screen.

The light-emitting module, the display module, the display screen and the display provided by embodiments of the present disclosure may achieve the following technical effects:
The formed light-emitting module is provided with no epitaxial growth substrate for forming the light-emitting unit layer, or is provided with the epitaxial growth substrate at least partially covering the light-emitting unit layer, to prevent influence of the epitaxial growth substrate on light which supports display as much as possible, thereby benefiting improvement of the display effect.

The above general description and the following description are exemplary and explanatory only, and are not intended to limit the present application.

### DESCRIPTION OF DRAWINGS

One or more embodiments are illustrated by the corresponding drawings, and the illustrations and drawings do not limit the embodiments. Elements having the same reference numerals in the drawings are shown as similar elements, and the drawings are not intended to limit the scale, wherein:
Figs. 1A and 1B are structural schematic diagrams of a light-emitting module provided by embodiments of the present disclosure;
Fig. 2 is another structural schematic diagram of the light-emitting module provided by embodiments of the present disclosure;
Figs. 3A and 3B are other structural schematic diagrams of the light-emitting module provided by embodiments of the present disclosure;
Figs. 4A, 4B, 4C, 4D, 4E, 4F, 4G and 4H are other structural schematic diagrams of the light-emitting module provided by embodiments of the present disclosure;
Fig. 5 is another structural schematic diagram of the light-emitting module provided by embodiments of the present disclosure;
Figs. 6A, 6B, 6C and 6D are other structural schematic diagrams of the light-emitting module provided by embodiments of the present disclosure;
Figs. 7A, 7B and 7C are other structural schematic diagrams of another structure of the light-emitting module provided by embodiments of the present disclosure;
Figs. 8A, 8B and 8C are other structural schematic diagrams of the light-emitting module provided by embodiments of the present disclosure;
Fig. 9 is another structural schematic diagram of the light-emitting module provided by embodiments of the present disclosure;
Fig. 10 is a structural schematic diagram of an intermediate layer structure provided by embodiments of the present disclosure;
Fig. 11 is another structural schematic diagram of the light-emitting module provided by embodiments of the present disclosure;
Fig. 12 is a structural schematic diagram of a light conversion layer provided by embodiments of the present disclosure;
Fig. 13 is another structural schematic diagram of the light-emitting module provided by embodiments of the present disclosure;
Fig. 14 is another structural schematic diagram of the light-emitting module provided by embodiments of the present disclosure;
Fig. 15 is another structural schematic diagram of the light-emitting module provided by embodiments of the present disclosure;
Fig. 16 is another structural schematic diagram of the light-emitting module provided by embodiments of the present disclosure;
Fig. 17 is another structural schematic diagram of the light-emitting module provided by embodiments of the present disclosure;
Figs. 18A and 18B are structural schematic diagrams of an electrical connection layer provided by embodiments of the present disclosure;
Figs. 19A, 19B, 19C and 19D are schematic diagrams of arrangement of conductive lines provided by embodiments of the present disclosure;
Figs. 20A, 20B and 20C are schematic diagrams of arrangement of light-emitting units provided by embodiments of the present disclosure;
Figs. 21A, 21B, 21C and 21D are schematic diagrams of a connection relationship between electrodes and conductive lines provided by embodiments of the present disclosure;
Fig. 22 is a structural schematic diagram of a display module provided by embodiments of the present disclosure;
Fig. 23 is a structural schematic diagram of a display screen provided by embodiments of the present disclosure; and
Fig. 24 is a structural schematic diagram of a display provided by embodiments of the present disclosure.

### Reference numerals:

100: light-emitting module; 130: electrical connection layer; 131: conductive hole; 133: first electrical connection layer; 135: second electrical connection layer; 137: first conductive hole; 139: second conductive hole; 141: first conductive line; 143: second conductive line; 150: light-emitting unit layer; 151: light-emitting unit; 153: first electrode; 155: second electrode; 170: light conversion layer; 171: pixel unit; 190: epitaxial growth substrate; 210: intermediate layer structure; 230: non-light-transmissive region; 250: light-transmissive region; 270: bottom layer; 290: light-transmissive material; S: light-exiting surface; P: backlight surface; 500: display module; 700: display screen; and 900: display.

### DETAILED DESCRIPTION

To understand features and technical contents of embodiments of the present disclosure in more detail, implementation of the embodiments of the present disclosure is described in detail below with reference to accompanying drawings; and the accompanying drawings are used for reference only, rather than limiting the embodiments of the present disclosure. In following technical description, for the convenience of explanation, a thorough understanding of the disclosed embodiments is provided through more details. However, one or more embodiments may be implemented without the details. In other cases, to simplify the accompanying drawings, well-known structures and apparatuses may be shown simplistically.

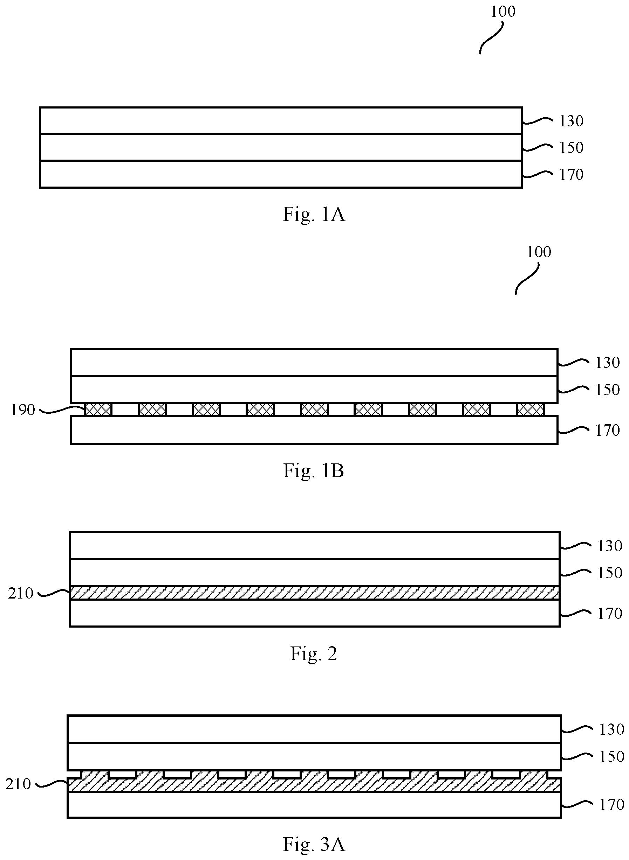

Referring to Figs. 1A and 1B, embodiments of the present disclosure provide a light-emitting module 100, comprising an electrical connection layer 130, a light-emitting unit layer 150 and a light conversion layer 170, wherein the light-emitting unit layer 150 is provided with no epitaxial growth substrate 190, or is provided with an epitaxial growth substrate 190 at least partially covering the light-emitting unit layer 150.

In this way, the formed light-emitting module 100 is provided with no epitaxial growth substrate 190 for forming the light-emitting unit layer 150, or is provided with the epitaxial growth substrate 190 at least partially covering the light-emitting unit layer 150, to prevent influence of the epitaxial growth substrate 190 on light which supports display as much as possible, thereby benefiting improvement of a display effect.

In some embodiments, as shown in Fig. 1A, the light-emitting unit layer 150 is provided with no epitaxial growth substrate 190.

In some embodiments, as shown in Fig. 1B, the light-emitting unit layer 150 is provided with the epitaxial growth substrate 190 at least partially covering the light-emitting unit layer 150. Optionally, the epitaxial growth substrate 190 may partially cover the light-emitting unit layer 150, or completely cover the light-emitting unit layer 150.

In some embodiments, whether the light-emitting unit layer 150 in the formed light-emitting module 100 is provided with the epitaxial growth substrate 190, the light-emitting unit layer 150 may be formed on the epitaxial growth substrate 190 in a process of forming the light-emitting module 100 in the manner of epitaxial growth or the like; and then the epitaxial growth substrate 190 may be partially or completely removed from the light-emitting unit layer 150. Optionally, a mode for removing the epitaxial growth substrate 190 may be considered according to actual conditions such as process requirements; for example, the epitaxial growth substrate 190 is partially or completely peeled off from the light-emitting unit layer 150 in a chemical or physical mode.

In some embodiments, as shown in Fig. 1A, the light-emitting unit layer 150 is provided with no epitaxial growth substrate 190; and the light conversion layer 170 may be directly arranged at the light-emitting unit layer 150.

Referring to Fig. 2, in some embodiments, an intermediate layer structure 210 that does not belong to the epitaxial growth substrate 190 may further be arranged between the light conversion layer 170 and the light-emitting unit layer 150.

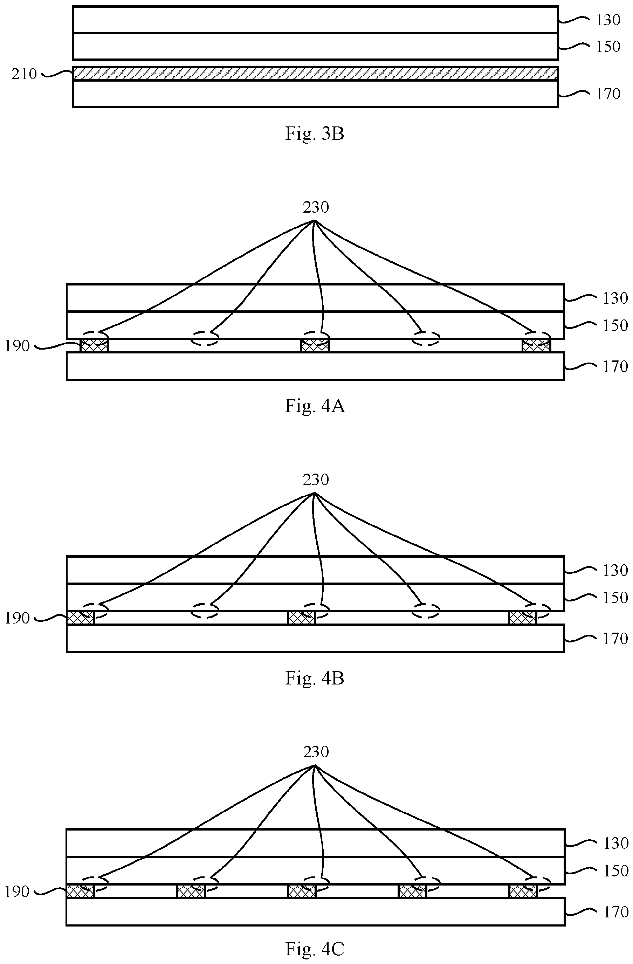

Referring to Figs. 3A and 3B in combination with Fig. 2, in some embodiments, the intermediate layer structure 210 may be in direct contact with the light-emitting unit layer 150, or may not be in direct contact with the light-emitting unit layer 150.

In some embodiments, as shown in Fig. 2, the intermediate layer structure 210 may be in direct contact with the light-emitting unit layer 150. Optionally, an entire region of a surface, facing the light-emitting unit layer 150, of the intermediate layer structure 210 may be in direct contact with the light-emitting unit layer 150.

In some embodiments, as shown in Fig. 3A, the intermediate layer structure 210 may be in direct contact with the light-emitting unit layer 150. Optionally, a partial region of the surface, facing the light-emitting unit layer 150, of the intermediate layer structure 210 may be in direct contact with the light-emitting unit layer 150. Optionally, other media may exist or other structures may be arranged in regions, not in direct contact with the light-emitting unit layer 150, of the intermediate layer structure 210.

In some embodiments, as shown in Fig. 3B, the intermediate layer structure 210 may be not in direct contact with the light-emitting unit layer 150. Optionally, other media may exist or other structures may be arranged in regions, not in direct contact with the light-emitting unit layer 150, of the intermediate layer structure 210.

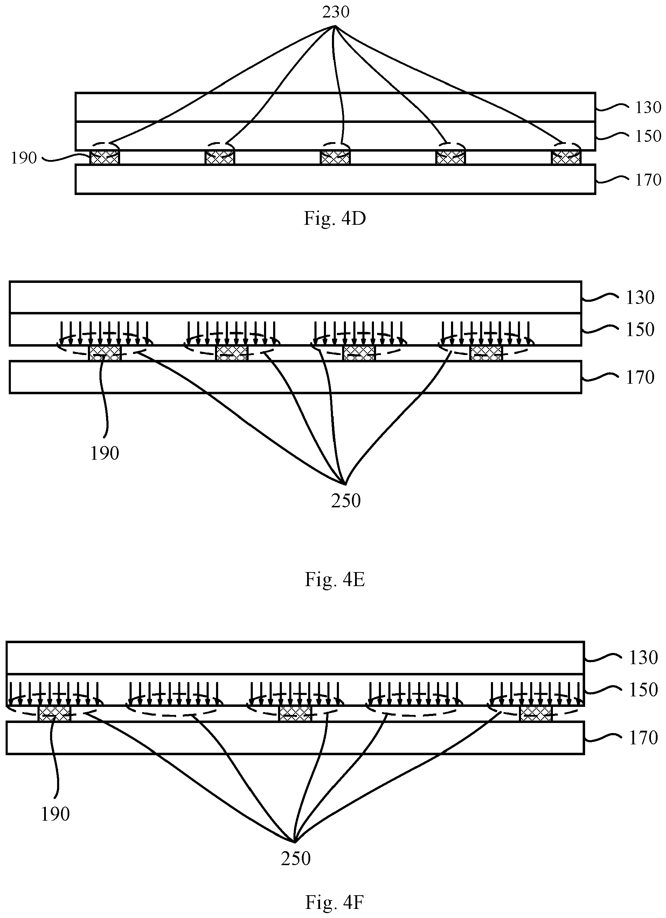

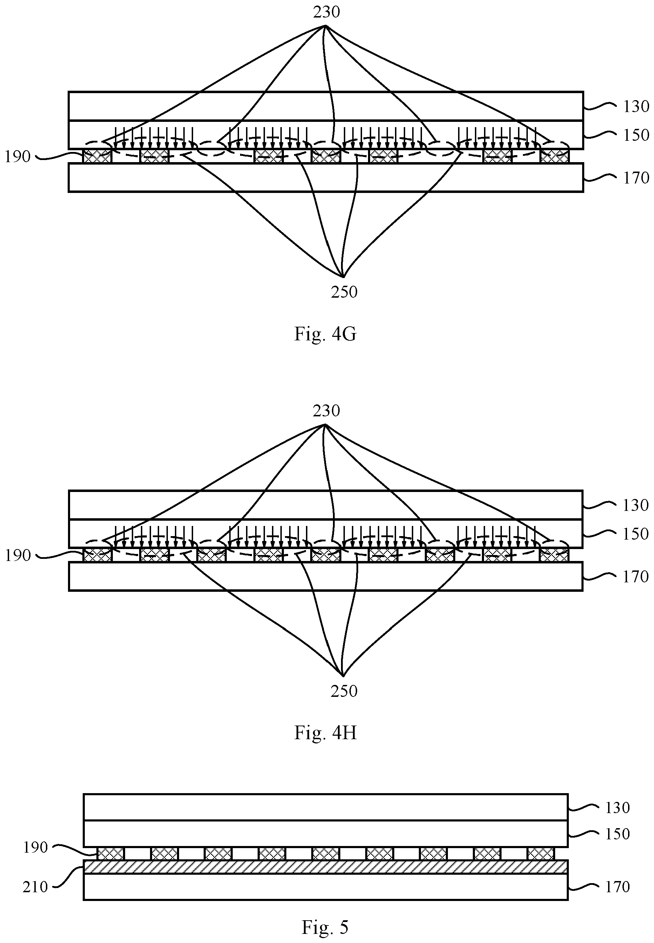

Referring to Figs. 4A, 4B, 4C, 4D, 4E, 4F, 4G and 4H, in some embodiments, the light-emitting unit layer 150 may be provided with the epitaxial growth substrate 190, wherein
the epitaxial growth substrate 190 may cover a part or whole of a non-light-transmissive region 230 of the light-emitting unit layer 150; or
the epitaxial growth substrate 190 may partially cover a light-transmissive region 250 of the light-emitting unit layer 150; or
the epitaxial growth substrate 190 may cover a part or whole of the non-light-transmissive region 230 of the light-emitting unit layer 150, and partially cover the light-transmissive region 250 of the light-emitting unit layer 150.

In some embodiments, referring to Figs. 4A, 4B, 4C and 4D, the epitaxial growth substrate 190 may cover a part or whole of the non-light-transmissive region 230 of the light-emitting unit layer 150.

In some embodiments, as shown in Fig. 4A, in all the non-light-transmissive regions 230 of the light-emitting unit layer 150, the epitaxial growth substrate 190 may cover a part of the non-light-transmissive regions 230 of the light-emitting unit layer 150. Optionally, for at least one non-light-transmissive region 230 of the light-emitting unit layer 150, the epitaxial growth substrate 190 may cover a whole of the non-light-transmissive region 230. Optionally, some non-light-transmissive regions 230 (e.g., at least one non-light-transmissive region 230) of the light-emitting unit layer 150 may not be covered by the epitaxial growth substrate 190. Optionally, when the epitaxial growth substrate 190 covers a whole of the at least one non-light-transmissive region 230 of the light-emitting unit layer 150, the epitaxial growth substrate 190 may cover a part of the at least one non-light-transmissive region 230 of the light-emitting unit layer 150 (as shown in Fig. 4B).

In some embodiments, as shown in Fig. 4B, in all the non-light-transmissive regions 230 of the light-emitting unit layer 150, the epitaxial growth substrate 190 may cover a part of the non-light-transmissive regions 230 of the light-emitting unit layer 150. Optionally, for at least one non-light-transmissive region 230 of the light-emitting unit layer 150, the epitaxial growth substrate 190 may cover a part of the non-light-transmissive region 230. Optionally, some non-light-transmissive regions 230 (e.g., at least one non-light-transmissive region 230) of the light-emitting unit layer 150 may not be covered by the epitaxial growth substrate 190. Optionally, when the epitaxial growth substrate 190 covers a part of the at least one non-light-transmissive region 230 of the light-emitting unit layer 150, the epitaxial growth substrate 190 may cover a whole of the at least one non-light-transmissive region 230 of the light-emitting unit layer 150 (as shown in Fig. 4A).

In some embodiments, as shown in Fig. 4C, in all the non-light-transmissive regions 230 of the light-emitting unit layer 150, the epitaxial growth substrate 190 may cover a part of the non-light-transmissive regions 230 of the light-emitting unit layer 150. Optionally, for each non-light-transmissive region 230 of the light-emitting unit layer 150, the epitaxial growth substrate 190 may cover a part of each non-light-transmissive region 230.

In some embodiments, as shown in Fig. 4D, in all the non-light-transmissive regions 230 of the light-emitting unit layer 150, the epitaxial growth substrate 190 may cover a whole of the non-light-transmissive regions 230 of the light-emitting unit layer 150.

In some embodiments, the epitaxial growth substrate 190 may cover part or all of the non-light-transmissive regions 230 of the light-emitting unit layer 150 according to actual conditions such as process requirements. Optionally, when the epitaxial growth substrate 190 covers a part of the non-light-transmissive regions 230 of the light-emitting unit layer 150, the different covering modes or other possible covering modes may be considered according to actual conditions such as process requirements.

In some embodiments, referring to Figs. 4E and 4F, whether the epitaxial growth substrate 190 covers part or all of the non-light-transmissive regions 230 of the light-emitting unit layer 150, the epitaxial growth substrate 190 may partially cover the light-transmissive regions 250 of the light-emitting unit layer 150. Optionally, an arrow graphic shown in the figures exemplarily indicates a trend of a part of light of the light-emitting unit layer 150. Optionally, for convenience of identification, the light-transmissive regions 250 of the light-emitting unit layer 150 are surrounded by dotted lines.

In some embodiments, as shown in Fig. 4E, the epitaxial growth substrate 190 may partially cover the light-transmissive regions 250 of the light-emitting unit layer 150. Optionally, for each light-transmissive region 250 of the light-emitting unit layer 150, the epitaxial growth substrate 190 may cover a part of each light-transmissive region 250. Optionally, when the epitaxial growth substrate 190 covers a part of the at least one light-transmissive region 250 of the light-emitting unit layer 150, the epitaxial growth substrate 190 may cover a whole of the at least one light-transmissive region 250 of the light-emitting unit layer 150.

In some embodiments, as shown in Fig. 4F, the epitaxial growth substrate 190 may partially cover the light-transmissive regions 250 of the light-emitting unit layer 150. Optionally, for at least one light-transmissive region 250 of the light-emitting unit layer 150, the epitaxial growth substrate 190 may cover a part of the light-transmissive region 250. Optionally, some light-transmissive regions 250 (e.g., at least one light-transmissive region 250) of the light-emitting unit layer 150 may not be covered by the epitaxial growth substrate 190. Optionally, when the epitaxial growth substrate 190 covers a part of the at least one light-transmissive region 250 of the light-emitting unit layer 150, the epitaxial growth substrate 190 may cover a whole of the at least one light-transmissive region 250 of the light-emitting unit layer 150.

In some embodiments, as shown in Fig. 4G, the epitaxial growth substrate 190 may cover a part of the non-light-transmissive regions 230 of the light-emitting unit layer 150, and partially cover the light-transmissive regions 250 of the light-emitting unit layer 150.

In some embodiments, as shown in Fig. 4H, the epitaxial growth substrate 190 may cover all of the non-light-transmissive regions 230 of the light-emitting unit layer 150, and partially cover the light-transmissive regions 250 of the light-emitting unit layer 150.

Figs. 4G and 4H only show a partial condition in which the epitaxial growth substrate 190 covers the light-transmissive regions 250 and the non-light-transmissive regions 230 of the light-emitting unit layer 150, exemplarily. In some embodiments, different conditions (and descriptions related to the accompanying drawings) shown in Figs. 4A, 4B, 4C and 4D in which the epitaxial growth substrate 190 covers the non-light-transmissive regions 230 of the light-emitting unit layer 150 may be combined with different conditions (and descriptions related to the accompanying drawings) shown in Figs. 4E and 4F in which the epitaxial growth substrate 190 covers the light-transmissive regions 250 of the light-emitting unit layer 150, so as to obtain different conditions in which the epitaxial growth substrate 190 covers the light-transmissive regions 250 and the non-light-transmissive regions 230 of the light-emitting unit layer 150. Optionally, other possible conditions in which the epitaxial growth substrate 190 covers the light-transmissive regions 250 and the non-light-transmissive regions 230 of the light-emitting unit layer 150 may also be obtained according to actual conditions such as process requirements.

Referring to Fig. 5, in some embodiments, an intermediate layer structure 210 that does not belong to the epitaxial growth substrate 190 may further be arranged between the light conversion layer 170 and the light-emitting unit layer 150.

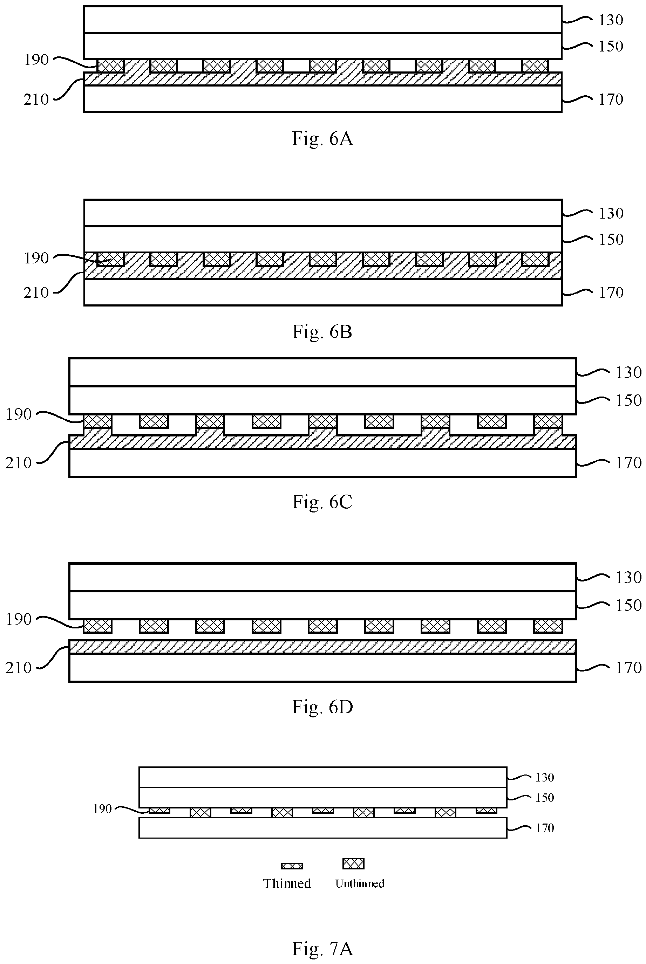

Referring to Figs. 6A, 6B, 6C and 6D, in some embodiments, the intermediate layer structure 210 may be in direct contact with the light-emitting unit layer 150, or may not be in direct contact with the light-emitting unit layer 150 in regions of the light-emitting unit layer 150 not covered by the epitaxial growth substrate 190. Optionally, the intermediate layer structure 210 may be in direct contact with the epitaxial growth substrate 190, or may not be in direct contact with the epitaxial growth substrate 190 in regions of the light-emitting unit layer 150 covered by the epitaxial growth substrate 190.

Referring to Figs. 6A and 6B in combination with Fig. 5, in some embodiments, the intermediate layer structure 210 may be in direct contact with the light-emitting unit layer 150, or may not be in direct contact with the light-emitting unit layer 150 in the regions of the light-emitting unit layer 150 not covered by the epitaxial growth substrate 190.

In some embodiments, in combination with Fig. 5, the intermediate layer structure 210 may not be in direct contact with the light-emitting unit layer 150 in all of the regions of the light-emitting unit layer 150 not covered by the epitaxial growth substrate 190.

In some embodiments, as shown in Fig. 6A, the intermediate layer structure 210 may be in direct contact with the light-emitting unit layer 150 in the regions of the light-emitting unit layer 150 not covered by the epitaxial growth substrate 190. Optionally, the intermediate layer structure 210 may be in direct contact with the light-emitting unit layer 150 in one part of the regions of the light-emitting unit layer 150 not covered by the epitaxial growth substrate 190; and the intermediate layer structure 210 may not be in direct contact with the light-emitting unit layer 150 in the other part of the regions of the light-emitting unit layer 150 not covered by the epitaxial growth substrate 190.

In some embodiments, as shown in Fig. 6B, the intermediate layer structure 210 may be in direct contact with the light-emitting unit layer 150 in the regions of the light-emitting unit layer 150 not covered by the epitaxial growth substrate 190. Optionally, the intermediate layer structure 210 may be in direct contact with the light-emitting unit layer 150 in all of the regions of the light-emitting unit layer 150 not covered by the epitaxial growth substrate 190.

In some embodiments, the contact between the intermediate layer structure 210 and the light-emitting unit layer 150 in the regions of the light-emitting unit layer 150 not covered by the epitaxial growth substrate 190 may be determined according to actual conditions such as process requirements.

In some embodiments, referring to Figs. 6C and 6D, whether the intermediate layer structure 210 is in direct contact with the light-emitting unit layer 150 in the regions of the light-emitting unit layer 150 not covered by the epitaxial growth substrate 190, the intermediate layer structure 210 may be in direct contact with the epitaxial growth substrate 190 or may not be in direct contact with the epitaxial growth substrate 190 in the regions of the light-emitting unit layer 150 covered by the epitaxial growth substrate 190.

In some embodiments, as shown in Fig. 6C, the intermediate layer structure 210 may be in direct contact with the epitaxial growth substrate 190 in the regions of the light-emitting unit layer 150 covered by the epitaxial growth substrate 190. Optionally, the intermediate layer structure 210 may be in direct contact with the epitaxial growth substrate 190 in one part of the regions of the light-emitting unit layer 150 covered by the epitaxial growth substrate 190; and the intermediate layer structure 210 may be in direct contact with the epitaxial growth substrate 190 in the other part of the regions of the light-emitting unit layer 150 covered by the epitaxial growth substrate 190.

In some embodiments, as shown in Fig. 6D, the intermediate layer structure 210 may be in direct contact with the epitaxial growth substrate 190 in all of the regions of the light-emitting unit layer 150 covered by the epitaxial growth substrate 190.

In some embodiments, other media may exist or other structures may be arranged in regions, not in direct contact with the light-emitting unit layer 150, of the intermediate layer structure 210.

In some embodiments, other media may exist or other structures may be arranged in regions, not in direct contact with the epitaxial growth substrate 190, of the intermediate layer structure 210.

Figs. 6C and 6D only show the contact between the intermediate layer structure 210 and the epitaxial growth substrate 190 in the regions of the light-emitting unit layer 150 covered by the epitaxial growth substrate 190, exemplarily. In some embodiments, different contact conditions (and the descriptions related to the accompanying drawings) shown in Figs.5, 6A and 6B between the intermediate layer structure 210 and the light-emitting unit layer 150 in the regions of the light-emitting unit layer 150 not covered by the epitaxial growth substrate 190 may be combined with different contact conditions (and the descriptions related to the accompanying drawings) shown in Figs. 6C and 6D between the intermediate layer structure 210 and the epitaxial growth substrate 190 in the regions of the light-emitting unit layer 150 covered by the epitaxial growth substrate 190, to obtain different contact conditions between the intermediate layer structure 210 and each of the light-emitting unit layer 150 and the epitaxial growth substrate 190. Optionally, other possible contact conditions between the intermediate layer structure 210 and each of the light-emitting unit layer 150 and the epitaxial growth substrate 190 may also be obtained according to actual conditions such as process requirements.

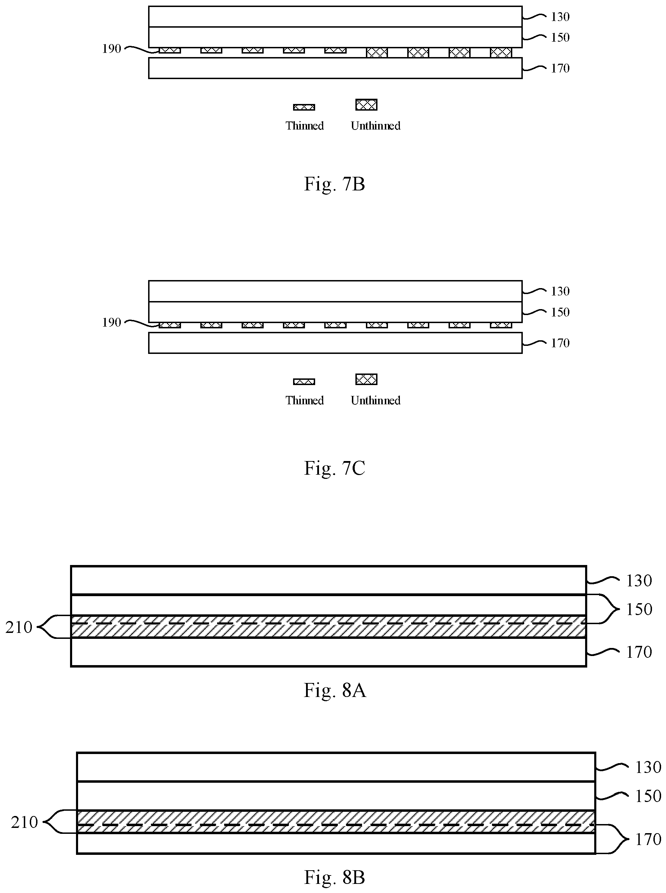

Referring to Figs. 7A, 7B and 7C, in some embodiments, a part or whole of the epitaxial growth substrate 190 may be thinned when the light-emitting module 100 is provided with the epitaxial growth substrate 190.

In some embodiments, as shown in Fig. 7A, part of the epitaxial growth substrate 190 is thinned when the light-emitting module 100 is provided with the epitaxial growth substrate 190. Optionally, thinned portions and unthinned portions of the epitaxial growth substrate 190 may be alternately arranged.

In some embodiments, as shown in Fig. 7B, part of the epitaxial growth substrate 190 is thinned when the light-emitting module 100 is provided with the epitaxial growth substrate 190. Optionally, at least a part or all of the thinned portions of the epitaxial growth substrate 190 and at least a part or all of the unthinned portions may be arranged by region; for example, all of the thinned portions of the epitaxial growth substrate 190 may be arranged in one region of the epitaxial growth substrate 190, and all of the unthinned portions of the epitaxial growth substrate 190 may be arranged in another region of the epitaxial growth substrate 190. Optionally, the regions may be continuous regions or scattered regions.

In some embodiments, as shown in Fig. 7C, a whole of the epitaxial growth substrate 190 is thinned when the light-emitting module 100 is provided with the epitaxial growth substrate 190.

In some embodiments, whether the epitaxial growth substrate 190 is thinned may be determined according to actual conditions such as process requirements. Optionally, a part or whole of the epitaxial growth substrate 190 is thinned may be determined according to actual conditions such as process requirements. Optionally, the thickness of the formed light-emitting module 100 may be reduced when the epitaxial growth substrate 190 is thinned, thereby benefiting improvement of the display effect.

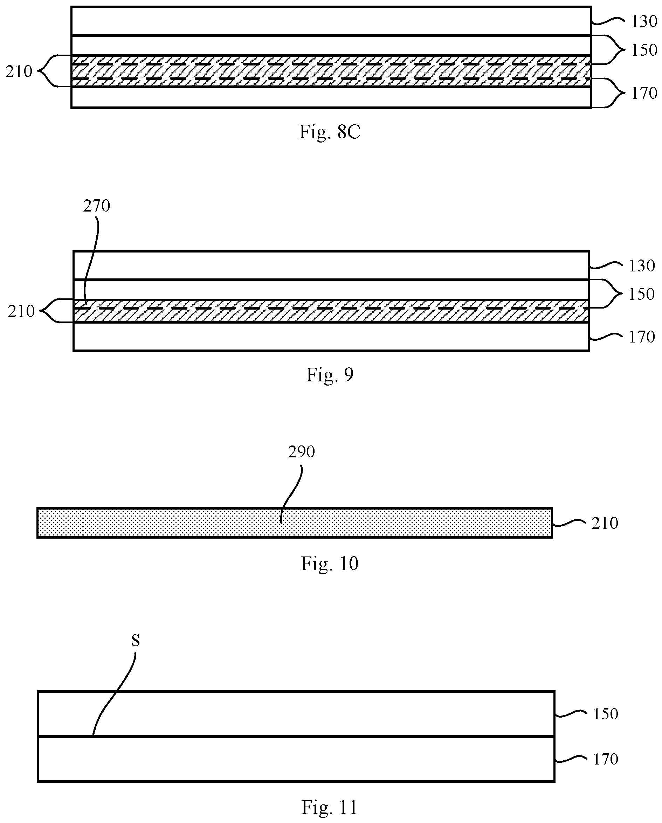

Referring to Figs. 8A, 8B and 8C in combination with Figs. 1A and 2, in some embodiments, the intermediate layer structure 210 may be arranged independently of the light-emitting unit layer 150 and the light conversion layer 170 whether the epitaxial growth substrate 190 is provided. Optionally, the intermediate layer structure 210 may comprise a partial structure of at least one of the light-emitting unit layer 150 and the light conversion layer 170 whether the epitaxial growth substrate 190 is provided.

For convenience and conciseness of description, the epitaxial growth substrate 190 is not shown in Figs. 8A, 8B and 8C. In some embodiments, arrangement relationships between the intermediate layer structure 210 and each of the light-emitting unit layer 150 and the light conversion layer 170 shown in Figs. 8A, 8B and 8C may be combined with the related descriptions and accompanying drawings of the epitaxial growth substrate 190 to obtain more possible arrangement relationships between the intermediate layer structure 210 and each of the epitaxial growth substrate 190, the light-emitting unit layer 150 and the light conversion layer 170.

In some embodiments, as shown in Figs. 1A and 2, the intermediate layer structure 210 may be arranged independently of the light-emitting unit layer 150 and the light conversion layer 170 when the epitaxial growth substrate 190 is not provided and the epitaxial growth substrate 190 is provided.

In some embodiments, as shown in Fig. 8A, the intermediate layer structure 210 may comprise a partial structure of the light-emitting unit layer 150; for example, a partial structure of the intermediate layer structure 210 may be used as a part of the light-emitting unit layer 150.

In some embodiments, as shown in Fig. 8B, the intermediate layer structure 210 may comprise a partial structure of the light conversion layer 170; for example, a partial structure of the intermediate layer structure 210 may be used as a part of the light conversion layer 170.

In some embodiments, as shown in Fig. 8C, the intermediate layer structure 210 may comprise the partial structure of the light-emitting unit layer 150 and the partial structure of the light conversion layer 170; for example, the partial structure of the intermediate layer structure 210 may be used as a part of the light-emitting unit layer 150, and the partial structure of the intermediate layer structure 210 may be used as a part of the light conversion layer 170.

Referring to Fig. 9, in some embodiments, the intermediate layer structure 210 may comprise a bottom layer 270, for bearing a light conversion material, in the light conversion layer 170; for example, the partial structure of the intermediate layer structure 210 may be used as the bottom layer 270, for bearing the light conversion material, in the light conversion layer 170.

In some embodiments, when the epitaxial growth substrate 190 is not provided, the arrangement relationships between the intermediate layer structure 210 and each of the light-emitting unit layer 150 and the light conversion layer 170 may be considered according to the actual conditions such as process requirements; the intermediate layer structure 210 may be arranged independently of the light-emitting unit layer 150 and the light conversion layer 170, or may comprise the partial structure of at least one of the light-emitting unit layer 150 and the light conversion layer 170. Optionally, when the epitaxial growth substrate 190 is provided, the arrangement relationships between the intermediate layer structure 210 and each of the epitaxial growth substrate 190, the light-emitting unit layer 150 and the light conversion layer 170 may be considered according to actual conditions such as process requirements; and the intermediate layer structure 210 may be arranged independently of the epitaxial growth substrate 190, the light-emitting unit layer 150 and the light conversion layer 170, or may comprise a partial structure of at least one of the epitaxial growth substrate 190, the light-emitting unit layer 150 and the light conversion layer 170.

Referring to Fig. 10, in some embodiments, the intermediate layer structure 210 may comprise a light-transmissive material 290. Optionally, the light-transmissive material 290 may be arranged in part or all of regions of the intermediate layer structure 210. Optionally, the arrangement regions of the light-transmissive material 290 in the intermediate layer structure 210 may correspond to part or all of the light-transmissive regions 250 of the light-emitting unit layer 150, so that part or all of light emitted by the light-emitting unit layer 150 may penetrate through the intermediate layer structure 210. Optionally, the arrangement regions of the light-transmissive material 290 in the intermediate layer structure 210 may correspond to part or all of the non-light-transmissive regions 230 of the light-emitting unit layer 150.

In some embodiments, the arrangement regions of the light-transmissive material 290 in the intermediate layer structure 210 may be considered according to actual conditions such as process requirements.

In some embodiments, the intermediate layer structure 210 may protect structures on both sides; for example, the intermediate layer structure 210 may try to avoid that the light conversion material (or other impurities) in the light conversion layer 170 enters the light-emitting unit layer 150 and influences the light-emitting unit layer 150.

In some embodiments, when the intermediate layer structure 210 is insulated, the intermediate layer structure 210 may also be used as an insulation layer.

In some embodiments, a refractive index of the intermediate layer structure 210 may be set according to actual conditions such as process requirements, so that the intermediate layer structure 210 may be used as a refractive index gradient layer for the structures on both sides, so as to alleviate a problem of too large refractive index difference between the structures on both sides of the intermediate layer structure 210, thereby reducing a light reflection loss of the light-emitting unit layer 150; for example, the refractive index of the intermediate layer structure 210 may be set between refractive indexes of the structures on both sides of the intermediate layer structure 210.

In some embodiments, the light-emitting unit layer 150 may be arranged between the electrical connection layer 130 and the light conversion layer 170.

Referring to Fig. 11, in some embodiments, the light conversion layer 170 may be arranged at a light-exiting surface S of the light-emitting unit layer 150.

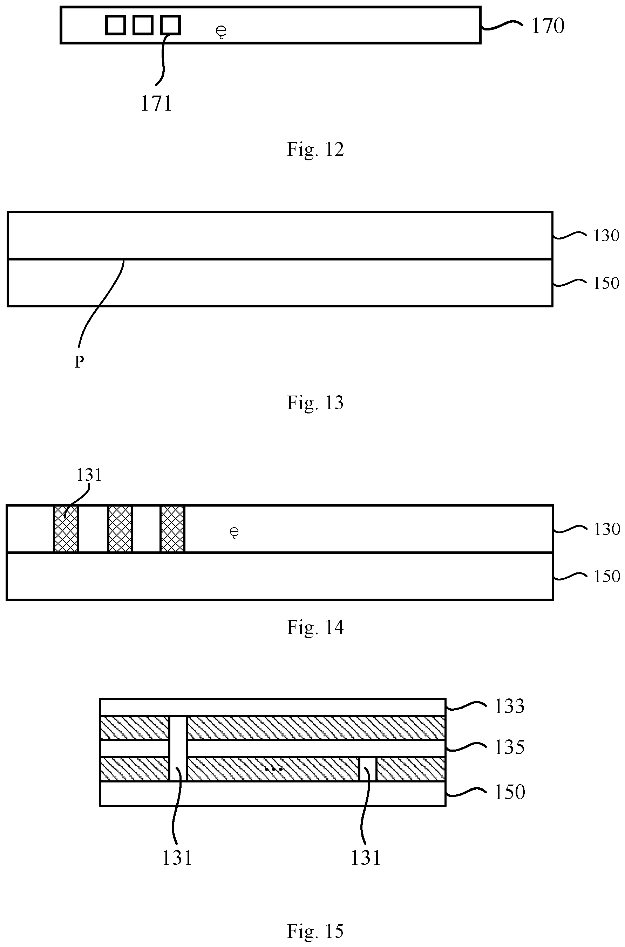

Referring to Fig. 12, in some embodiments, the light conversion layer 170 may comprise a plurality of pixel units 171.

In some embodiments, the plurality of pixel units 171 may comprise at least one of pixels and subpixels.

In some embodiments, the plurality of pixel units 171 may comprise at least one pixel. Optionally, the plurality of pixel units 171 may comprise at least one subpixel. Optionally, the plurality of pixel units 171 may comprise at least one pixel and at least one subpixel.

In some embodiments, the pixel units 171 may be arranged according to actual conditions such as process requirements, so that the plurality of pixel units 171 comprise at least one of pixels and subpixels. Optionally, whether pixels and subpixels are included, the pixel units 171 may comprise other display (e.g., light conversion) structures besides the pixels and the subpixels.

In some embodiments, at least two pixel units 171 of the plurality of pixel units 171 may include the same or different light conversion materials. Optionally, main or all components of the light conversion material may include at least one of fluorescent powder, quantum dots and other materials.

Referring to Fig. 13, in some embodiments, the electrical connection layer 130 may be arranged at a backlight surface P of the light-emitting unit layer 150.

Referring to Fig. 14, in some embodiments, the electrical connection layer 130 may be provided with a plurality of conductive holes 131; and the electrical connection layer 130 may be electrically connected with the light-emitting unit layer 150 through the plurality of conductive holes 131.

Referring to Fig. 15, in some embodiments, the electrical connection layer 130 may at least comprise a first electrical connection layer 133 and a second electrical connection layer 135; and optionally, the first electrical connection layer 133 and the second electrical connection layer 135 may be electrically connected with the light-emitting unit layer 150 through the plurality of conductive holes 131.

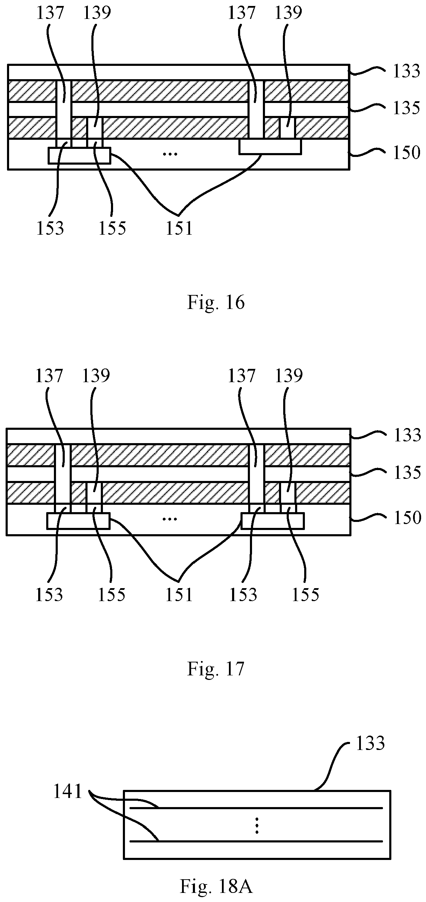

Referring to Fig. 16, in some embodiments, the light-emitting unit layer 150 may be provided with a plurality of light-emitting units 151; and at least one of the plurality of light-emitting units 151 may be provided with at least one first electrode 153 and at least one second electrode 155. Optionally, the plurality of conductive holes 131 may comprise at least a plurality of first conductive holes 137 and a plurality of second conductive holes 139. Optionally, at least one first electrode 153 may be electrically connected with the first electrical connection layer 133 through at least one of the plurality of first conductive holes 137; and at least one second electrode 155 may be electrically connected with the second electrical connection layer 135 through at least one of the plurality of second conductive holes 139.

Referring to Fig. 17, in some embodiments, each light-emitting unit 151 of the plurality of light-emitting units 151 may be provided with a first electrode 153 and a second electrode 155. Optionally, the plurality of conductive holes 131 may comprise a plurality of first conductive holes 137 and a plurality of second conductive holes 139. Optionally, the first electrodes 153 of different light-emitting units 151 in the plurality of light-emitting units 151 may be electrically connected with the first electrical connection layer 133 through different first conductive holes 137; and the second electrodes 155 of different light-emitting units 151 in the plurality of light-emitting units 151 may be electrically connected with the second electrical connection layer 135 through different second conductive holes 139.

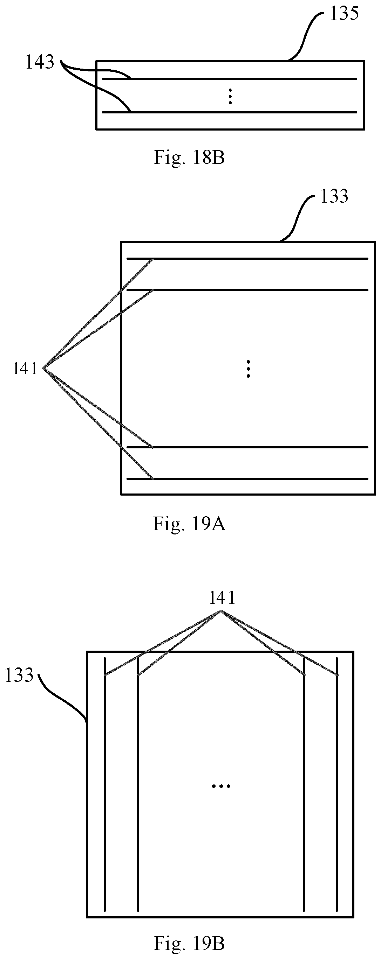

Referring to Figs. 18A and 18B, in some embodiments, at least one of the first electrical connection layer 133 and the second electrical connection layer 135 may be arranged in the following modes:
the first electrical connection layer 133 comprises at least one layer of first conductive lines 141;
the second electrical connection layer 135 comprises at least one layer of second conductive lines 143.

In some embodiments, as shown in Fig. 18A, the first conductive lines 141 of different layers are exemplified from top to bottom in the first electrical connection layer 133. Optionally, each wire segment in the first electrical connection layer 133 represents a layer of first conductive lines 141.

In some embodiments, as shown in Fig. 18B, the second conductive lines 143 of different layers are exemplified from top to bottom in the second electrical connection layer 135. Optionally, each wire segment in the second electrical connection layer 135 represents a layer of second conductive lines 143.

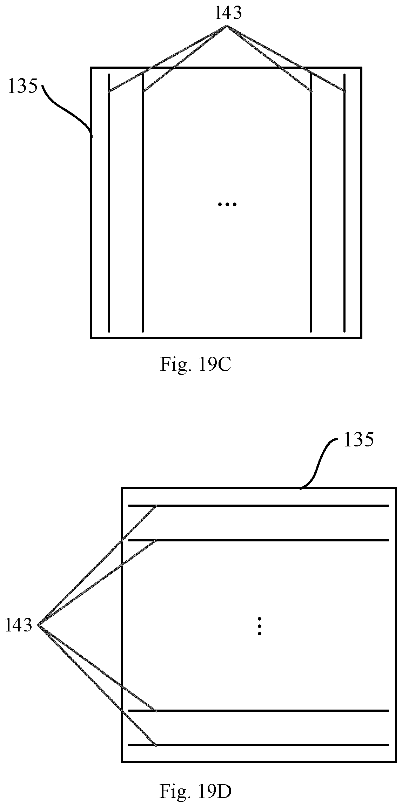

Referring to Figs. 19A, 19B, 19C and 19D, in some embodiments, at least one of the first conductive lines 141 and the second conductive lines 143 may be in array arrangement.

In some embodiments, at least one of the first conductive lines 141 and the second conductive lines 143 may be in array arrangement in a form of rows or columns.

In some embodiments, as shown in Figs. 19A and 19B, the first conductive lines 141 may be in array arrangement in a form of rows; and the second conductive lines 143 may be in array arrangement in a form of columns. Optionally, as shown in Figs. 19C and 19D, the first conductive lines 141 may be in array arrangement in a form of columns; and the second conductive lines 143 may be in array arrangement in a form of rows.

As shown in Figs. 19A, 19B, 19C and 19D, the array arrangement mode of the first conductive lines 141 and the second conductive lines 143 may be a determinant. Optionally, the array arrangement mode of the first conductive lines 141 and the second conductive lines 143 may be different from that shown in Figs. 19A, 19B, 19C and 19D, but may be arrangement modes in other array shapes, such as circular, oval, triangular and other array arrangement modes.

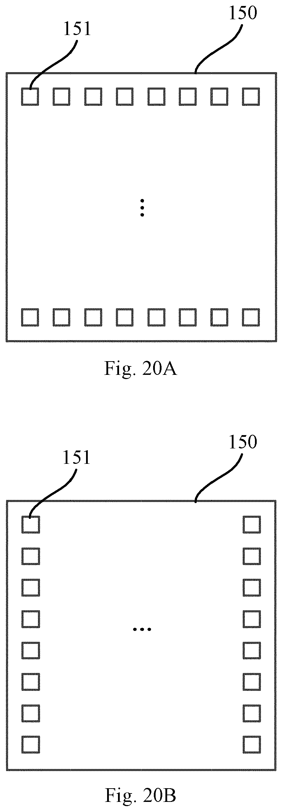

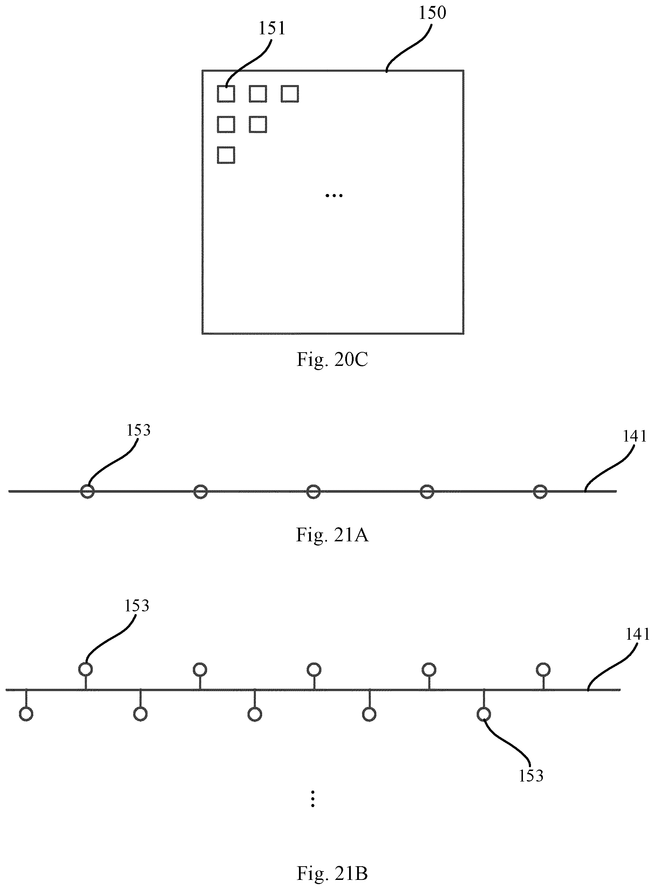

Referring to Figs. 20A, 20B and 20C, in some embodiments, the plurality of light-emitting devices 151 may be in array arrangement.

In some embodiments, the plurality of light-emitting units 151 may be in array arrangement in a form of rows or columns.

In some embodiments, as shown in Fig. 20A, the plurality of light-emitting units 151 may be in array arrangement in a form of rows. Optionally, at least one row of light-emitting units 151, such as one, two, three or more rows of light-emitting units 151, may be provided.

In some embodiments, as shown in Fig. 20B, the plurality of light-emitting units 151 may be in array arrangement in a form of columns. Optionally, at least one row of light-emitting units 151, such as one, two, three or more columns of light-emitting units 151, may be provided.

In some embodiments, as shown in Fig. 20C, the plurality of light-emitting units 151 may be in array arrangement in a form of rows and columns. Optionally, a plurality of rows and columns of light-emitting units 151 may be provided.

As shown in Figs. 20A, 20B and 20C, the array arrangement mode of the plurality of light-emitting units 151 may be a determinant. Optionally, the array arrangement mode of the plurality of light-emitting units 151 may be different from that shown in Figs. 20A, 20B and 20C, but may be arrangement modes in other array shapes, such as circular, oval, triangular and other array arrangement modes.

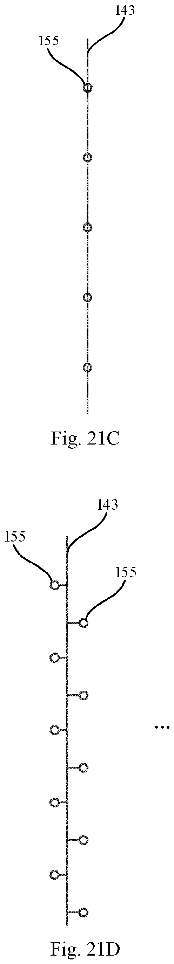

Referring to Figs. 21A, 21B, 21C and 21D, in some embodiments, the first electrodes 153 of the plurality of light-emitting units 151 in at least one row may be electrically connected with the same first conductive line 141; and the second electrodes 155 of the plurality of light-emitting units 151 in at least one column may be electrically connected with the same second conductive line 143.

In some embodiments, as shown in Fig. 21A, the first electrodes 153 of the plurality of light-emitting units 151 in a row are electrically connected with the same first conductive line 141.

In some embodiments, as shown in Fig. 21B, the first electrodes 153 of the plurality of light-emitting units 151 in at least two rows are electrically connected with the same first conductive line 141; for example, the first electrodes 153 of the plurality of light-emitting units 151 in two, three or more rows are electrically connected with the same first conductive line 141.

In some embodiments, as shown in Fig. 21C, the second electrodes 155 of the plurality of light-emitting units 151 in a column are electrically connected with the same second conductive line 143.

In some embodiments, as shown in Fig. 21D, the second electrodes 155 of the plurality of light-emitting units 151 in at least two columns are electrically connected with the same second conductive line 143; for example, the second electrodes 155 of the plurality of light-emitting units 151 in two, three or more columns are electrically connected with the same second conductive line 143.

In some embodiments, the number of rows and columns of the electrodes electrically connected with the same conductive line may be determined according to actual conditions such as process requirements. Optionally, the number of rows of the first electrodes 153 electrically connected with the same first conductive line 141 may be determined according to actual conditions such as process requirements, and the number of columns of the second electrodes 155 electrically connected with the same second conductive line 143 may be determined according to actual conditions such as process requirements.

In some embodiments, the plurality of light-emitting units 151 may comprise at least one of LED, Mini LED and Micro LED. Optionally, the plurality of light-emitting units 151 may comprise at least one LED. Optionally, the plurality of light-emitting units 151 may comprise at least one Mini LED. Optionally, the plurality of light-emitting units 151 may comprise at least one Mini LED. Optionally, the plurality of light-emitting units 151 may comprise at least one LED and at least one Mini LED. Optionally, the plurality of light-emitting units 151 may comprise at least one LED and at least one Micro LED. Optionally, the plurality of light-emitting units 151 may comprise at least one Mini LED and at least one Micro LED. Optionally, the plurality of light-emitting units 151 may comprise at least one LED, at least one Mini LED and at least one Micro LED. Optionally, the plurality of light-emitting units 151 may comprise other light-emitting devices besides LED, Mini LED and Micro LED.

In some embodiments, types of devices of the light-emitting unit 151, such as LED, Mini LED, Micro LED or other light-emitting devices, may be determined according to actual conditions such as process requirements.

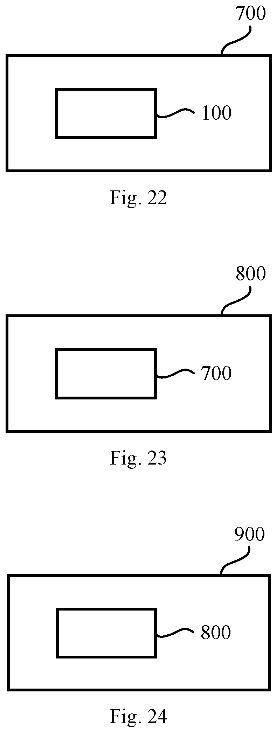

Referring to Fig. 22, embodiments of the present disclosure provide a display module 500, comprising the light-emitting module 100. In some embodiments, the display module 500 may support 3D display.

Referring to Fig. 23, embodiments of the present disclosure provide a display screen 700, comprising the display module 500. In some embodiments, the display screen 700 may perform 3D display.

Referring to Fig. 24, embodiments of the present disclosure provide a display 900, comprising the display screen 700. In some embodiments, the display 900 may perform 3D display. In some embodiments, the display 900 may further comprise other components for supporting normal operation of the display 900, such as at least one of a communication interface, a framework, a control circuit and the like.

In terms of the light-emitting module, the display module, the display screen and the display provided by embodiments, the formed light-emitting module is provided with no epitaxial growth substrate for forming the light-emitting unit layer, or is provided with the epitaxial growth substrate at least partially covering the light-emitting unit layer, to prevent influence of the epitaxial growth substrate on light which supports display as much as possible, thereby benefiting improvement of the display effect.

The above description and drawings sufficiently illustrate the embodiments of the present disclosure to enable those skilled in the art to practice them. Other embodiments may comprise structural, logical, electrical, process, and other changes. The embodiments represent only possible changes. Unless expressly required, individual components and functions are optional and the order of operations may be changed. Parts and features of some embodiments may be included in or substituted for parts and features of other embodiments. The scope of the disclosed embodiments includes the full scope of the claims, and all available equivalents of the claims. When used in the present application, although the terms of "first", "second", etc. may be possibly used in the present application to describe various elements, these elements should not be limited by these terms. These terms are only used to distinguish one element from another. For example, without changing the meaning of the description, a first element may be called as a second element, and similarly, the second element may be called as the first element, as long as all of "the first elements" that appear are consistently renamed and all of "the second elements" that appear are consistently renamed. The first element and the second element are both elements, but may not be the same element. Moreover, the terms used in the present application are used to describe the embodiments only and not to limit the claims. As used in the illustration of the embodiments and the claims, unless clearly indicated in the context, the singular forms "a", "an" and "the" are also intended to include the plural forms. Similarly, the term "and/or" as used in the present application is meant to include any and all possible combinations of one or more of the associated listings. In addition, when used in the present application, the term "comprise" and its variations "comprises" and/or "comprising", etc., refer to the presence of stated features, integers, steps, operations, elements, and/or components, but does not preclude the presence or addition of one or more other features, integers, steps, operations, elements, components and/or groupings of these. Without further limitations, an element limited by the phrase "comprises a..." does not preclude the presence of additional identical elements in the process, method or device that includes the element. Herein, the difference of each embodiment from each other may be the focus of explanation. The same and similar parts among all of the embodiments may be referred to each other. For the method and product disclosed by the embodiments, if the method and product correspond to a method part disclosed by the embodiments, the description of the method part can be referred to for the related part.

Those skilled in the art may recognize that the units and algorithm steps of each example described in conjunction with the embodiments disclosed herein can be implemented in electronic hardware, or a combination of computer software and electronic hardware. Whether these functions are performed in hardware or software may depend on the specific application and design constraints of the technical solution. Those skilled in the art may use different methods for implementing the described functions for each particular application, but such implementations should not be considered beyond the scope of the embodiments of the present disclosure. Those skilled in the art may clearly understand that, for the convenience and brevity of description, the corresponding processes in the above method embodiments may be referred to for the working processes of the above systems, devices and units, which will not be repeated here.

In the embodiments disclosed herein, the disclosed method and product (including, but not limited to the apparatus and the device) may be realized in other ways. For example, the device embodiments described above are merely schematic. For example, the division of the units may be only a logical functional division, and may be an additional division manner in actual realization. For example, multiple units or components may be combined or integrated into another system, or some features may be ignored or not executed. In addition, the displayed or discussed mutual coupling or direct coupling or communication connection may be indirect coupling or communication connection through some interfaces, devices or units, and may be electrical, mechanical or other forms. The units described as separate components may or may not be physically separated, and the components shown as the units may or may not be physical units, that is, may be located in one place, or may be distributed on multiple network units. The present embodiments may be implemented by selecting some or all of the units according to actual needs. In addition, each functional unit in the embodiments of the present disclosure may be integrated into one processing unit, or each unit may exist physically alone, or two or more units may be integrated into one unit.

In the drawings, considering clarity and description, the width, length and thickness of structures of components or layers can be exaggerated. When a structure of a component or layer is described to be "arranged" (or "installed" or "laid" or "fitted" or "coated" or similar illustration) "above" or "on" another component or layer, the structure of the component or layer may be directly "arranged" "above" or "on" another component or layer, or there may be a structure of an intermediate component or layer between the component or layer and another component or layer, or even a part of the component or layer is embedded in another component or layer.

## Claims

1. A light-emitting module, comprising: an electrical connection layer, a light-emitting unit layer and a light conversion layer, wherein
the light-emitting unit layer is provided with no epitaxial growth substrate, or is provided with an epitaxial growth substrate at least partially covering the light-emitting unit layer.

2. The light-emitting module according to claim 1, wherein the light-emitting unit layer is provided with no epitaxial growth substrate; and the light conversion layer is directly arranged at the light-emitting unit layer.

3. The light-emitting module according to claim 2, wherein an intermediate layer structure that does not belong to the epitaxial growth substrate is further arranged between the light conversion layer and the light-emitting unit layer.

4. The light-emitting module according to claim 3, wherein the intermediate layer structure is in direct contact with the light-emitting unit layer, or is not in direct contact with the light-emitting unit layer.

5. The light-emitting module according to claim 1, wherein the light-emitting unit layer is provided with the epitaxial growth substrate, wherein:
the epitaxial growth substrate covers a part or whole of a non-light-transmissive region of the light-emitting unit layer; or
the epitaxial growth substrate partially covers a light-transmissive region of the light-emitting unit layer; or
the epitaxial growth substrate covers a part or whole of a non-light-transmissive region of the light-emitting unit layer, and partially covers a light-transmissive region of the light-emitting unit layer.

6. The light-emitting module according to claim 5, wherein an intermediate layer structure that does not belong to the epitaxial growth substrate is further arranged between the light conversion layer and the light-emitting unit layer.

7. The light-emitting module according to claim 6, wherein
the intermediate layer structure is in direct contact with the light-emitting unit layer, or is not in direct contact with the light-emitting unit layer in a region of the light-emitting unit layer not covered by the epitaxial growth substrate; or
the intermediate layer structure is in direct contact with the epitaxial growth substrate, or is not in direct contact with the epitaxial growth substrate in a region of the light-emitting unit layer covered by the epitaxial growth substrate.

8. The light-emitting module according to any one of claims 1 and 5-7, wherein a part or whole of the epitaxial growth substrate is thinned when the light-emitting module is provided with the epitaxial growth substrate.

9. The light-emitting module according to claim 3, 4, 6 or 7, wherein
the intermediate layer structure is arranged independently of the light-emitting unit layer and the light conversion layer; or
the intermediate layer structure comprises a partial structure of at least one of the light-emitting unit layer and the light conversion layer.

10. The light-emitting module according to claim 9, wherein the intermediate layer structure comprises a bottom layer for bearing a light conversion material in the light conversion layer.

11. The light-emitting module according to claim 3, 4, 6, 7, 9 or 10, wherein the intermediate layer structure comprises a light-transmissive material.

12. The light-emitting module according to any one of claims 1-11, wherein the light-emitting unit layer is arranged between the electrical connection layer and the light conversion layer.

13. The light-emitting module according to claim 12, wherein the light conversion layer is arranged at a light-exiting surface of the light-emitting unit layer.

14. The light-emitting module according to claim 13, wherein the light conversion layer comprises a plurality of pixel units.

15. The light-emitting module according to claim 14, wherein the plurality of pixel units comprise:
at least one of pixels and subpixels.

16. The light-emitting module according to claim 15, wherein at least two pixel units of the plurality of pixel units comprise same or different light conversion materials.

17. The light-emitting module according to any one of claims 1-16, wherein the electrical connection layer is arranged at a backlight surface of the light-emitting unit layer.

18. The light-emitting module according to claim 17, wherein the electrical connection layer is provided with a plurality of conductive holes; and the electrical connection layer is electrically connected with the light-emitting unit layer through the plurality of conductive holes.

19. The light-emitting module according to claim 18, wherein the electrical connection layer at least comprises a first electrical connection layer and a second electrical connection layer; and the first electrical connection layer and the second electrical connection layer are electrically connected with the light-emitting unit layer through the plurality of conductive holes.

20. The light-emitting module according to claim 19, wherein
the light-emitting unit layer is provided with a plurality of light-emitting units; and at least one of the plurality of light-emitting units is provided with at least one first electrode and at least one second electrode;
the plurality of conductive holes comprise at least a plurality of first conductive holes and a plurality of second conductive holes;
the at least one first electrode is electrically connected with the first electrical connection layer through at least one of the plurality of first conductive holes; and the at least one second electrode is electrically connected with the second electrical connection layer through at least one of the plurality of second conductive holes.

21. The light-emitting module according to claim 20, wherein
each light-emitting unit of the plurality of light-emitting units is provided with a first electrode and a second electrode;
the plurality of conductive holes comprise a plurality of first conductive holes and a plurality of second conductive holes;
first electrodes of different light-emitting units in the plurality of light-emitting units are electrically connected with the first electrical connection layer through different first conductive holes; and second electrodes of different light-emitting units in the plurality of light-emitting units are electrically connected with the second electrical connection layer through different second conductive holes.

22. The light-emitting module according to claim 20, wherein at least one of the first electrical connection layer and the second electrical connection layer is arranged in following modes:
the first electrical connection layer comprises at least one layer of first conductive lines;
the second electrical connection layer comprises at least one layer of second conductive lines.

23. The light-emitting module according to claim 22, wherein at least one of the first conductive lines and the second conductive lines is in array arrangement.

24. The light-emitting module according to claim 23, wherein at least one of the first conductive lines and the second conductive lines is in array arrangement in a form of rows or columns.

25. The light-emitting module according to claim 22, wherein the plurality of light-emitting units are in array arrangement.

26. The light-emitting module according to claim 25, wherein the plurality of light-emitting units are in array arrangement in a form of rows or columns.

27. The light-emitting module according to claim 26, wherein first electrodes of the plurality of light-emitting units in at least one row are electrically connected with the same first conductive line; and second electrodes of the plurality of light-emitting units in at least one column are electrically connected with the same second conductive line.

28. The light-emitting module according to claim 20, wherein the plurality of light-emitting units comprise: at least one of a light-emitting diode (LED), a Mini LED and a Micro LED.

29. A display module, comprising the light-emitting module of any one of claims 1-28.

30. A display screen, comprising the display module of claim 29.

31. A display, comprising the display screen of claim 30.
